# EUROPEAN PATENT APPLICATION

(11) **EP 0 978 937 A1**
(43) Date of publication of application: **09.02.2000**
(21) Application number: 98904417.7
(22) Date of filing: 24.02.1998
(51) Int. Cl.: H03H 9/145, H03H 9/25, H03H 9/64

(54) **SURFACE ACOUSTIC WAVE ELEMENT**

(71) Applicant: MITSUBISHI DENKI KABUSHIKI KAISHA, Tokyo 100-8310 (JP)
(72) Inventor: SAKAI, Atsushi, Mitsubishi Denki K. K., Tokyo 100-8310 (JP)
(74) Representative: Sajda, Wolf E., Dipl.-Phys.
(86) International application number: JP9800728
(87) International publication number: WO9944284

(57) **Abstract**

The surface acoustic wave device according to the present invention comprises: a substrate 6); a first inter-digital transducer (7) for transducing an input electric signal to an output surface acoustic wave, which is disposed on the substrate and has a set of first comb-formed electrode fingers (7a); a second inter-digital transducer (8) for transducing the input surface acoustic wave signal to an output electric signal, which is disposed on the substrate and has a set of second comb-formed electrode fingers (8a); wherein the proportion of the width of a finger in the first comb-formed electrode fingers (7a) to the width of the spacing between the adjacent fingers in the first comb-formed electrode fingers can be different from the proportion of the width of a finger in the second comb-formed electrode fingers (8a) to the width of the spacing between the adjacent fingers in the second comb-formed electrode fingers.

It is possible to adjust the capacitance component of the input impedance and output impedance by the structure itself of the first and second inter-digital transducers, so that the impedances can be matched with that of outer circuits. As a result, the total size of the surface acoustic wave device can be downsized.

## Description

### 〈Technical Field〉

The present invention relates to a surface acoustic wave device, in which the input and output impedances are adjusted by inter-digital transducers.

### 〈Background Art〉

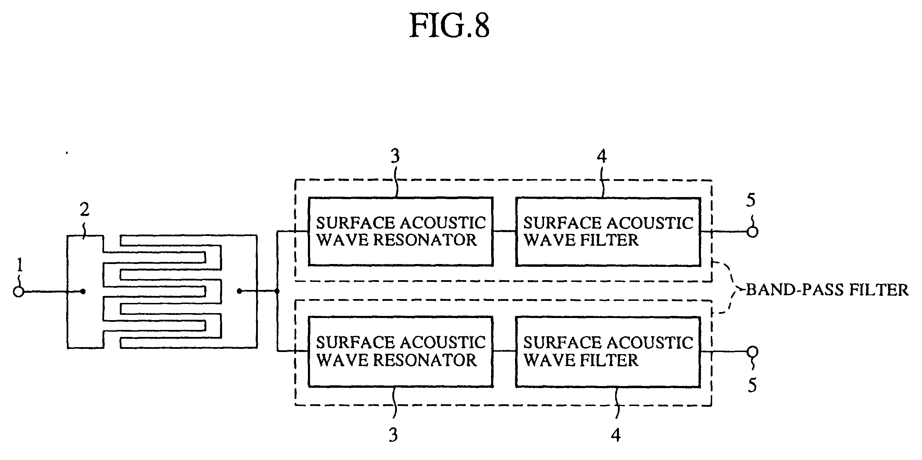

The surface acoustic wave device in the prior art disclosed in the general assembly of the Society of Electronics, Information, and Communication in 1997, which is held in Japan, is shown in Fig.8 (No. A-11-14).

Fig.8 shows a block diagram of the surface acoustic wave device in the prior art, having capacitance elements constituted by a pair of comb-formed electrodes. In Fig.8, the reference numeral 1 denotes an input terminal. The input terminal 1 is connected to a capacitance element 2, constituted from a pair of comb-formed electrodes. The capacitance element 2 is connected to two surface acoustic wave resonators 3. And each of the surface acoustic wave resonator 3 is connected to a surface acoustic wave filter 4. And each of the surface acoustic wave filters 4 is connected to an output terminal 5.

The combination of the surface acoustic wave resonator 3 and the surface acoustic wave filter 4 forms a band-pass filter. In this prior art, two sets of band-pass filters are connected in parallel with the capacitance element 2 to form a surface acoustic wave device, having one input terminal and two output terminals corresponding to two different passing-through frequency bands.

The capacitance element 2 constituted from a pair of comb-formed electrodes functions as an impedance matching circuit at the input side. The input impedance is adjusted by connecting capacitance serially between the input terminal 1 and the surface acoustic wave resonators 3.

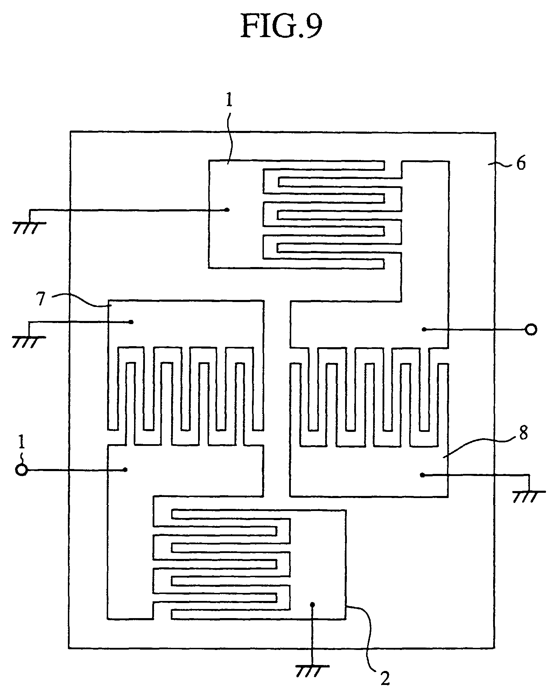

A plan view of another example of a surface acoustic wave device in the prior art is shown in Fig.9. Also this surface acoustic wave device has capacitance elements 2 constituted from a pair of comb-formed electrodes.

In Fig.9, reference numeral 6 denotes a substrate of the device. The substrate 6 is a propagation media of the surface acoustic wave. Reference numeral 7 denotes an input side inter-digital transducer. Hereinafter an inter-digital transducer is referred by "IDT". An input terminal 1 is connected with the input side IDT 7. The input side IDT 7 is disposed on the substrate 6, and combined with a capacitance element 2. Reference numeral 8 denotes an output side IDT, which is connected with an output terminal 5. The output side IDT 8 is disposed on the substrate 6, and combined with another capacitance element 2.

Components in Fig. 9 identical or equivalent to components in the surface acoustic wave device in the prior art shown in Fig.8 are referred by corresponding reference numerals, and their explanations are omitted, here. Only points of difference are explained.

The essential frequency characteristics of this surface acoustic wave device are determined by the input side IDT 7 and the output side IDT 8. The input impedance and the output impedance of the surface acoustic wave device are adjusted by the capacitance elements 2, connected to the input terminal 1 and the output terminal 5, respectively.

As explained, the input impedance and the output impedance of the surface acoustic wave devices of the prior art are changed by a capacitance elements 2 constituted from a comb-formed electrodes, which are connected to each of the input terminal 1 and the output terminal 5, so as to match with outer circuits. Therefore, the size of the substrate 6 increases, due to the large area of the comb-formed electrodes. As a result, the surface acoustic wave devices in the prior art has the drawbacks that there is a limit in downsizing of the surface acoustic wave device.

### 〈Disclosure of Invention〉

An object of the present invention is to eliminate the drawback of the surface acoustic wave devices in the prior art.

Another object of the present invention is to propose a surface acoustic device, in which the capacitance component of the input impedance and output impedance can be adjusted using no capacitance element, so that the input impedance and output impedance can be matched with outer circuits.

For attaining these objects, a surface acoustic wave device is proposed according to the present invention, which comprises: a substrate; a first inter-digital transducer for transducing an input electric signal to an output surface acoustic wave, which is disposed on the substrate and has a set of first comb-formed electrode fingers; a second inter-digital transducer for transducing the input surface acoustic wave signal to an output electric signal, which is disposed on the substrate and has a set of second comb-formed electrode fingers; wherein the proportion of the width of a finger in the first comb-formed electrode fingers to the width of the spacing between the adjacent fingers in the first comb-formed electrode fingers can be different from the proportion of the width of a finger in the second comb-formed electrode fingers to the width of the spacing between the adjacent fingers in the second comb-formed electrode fingers.

In an embodiment of the surface acoustic wave device according to the present invention, the width of a finger in the first and/or second comb-formed electrode fingers is larger than three times of the width of spacing between the adjacent fingers in the first comb-formed electrode fingers.

In an embodiment of the surface acoustic wave device according to the present invention, the widths of the first and/or second comb-formed electrode fingers are constant.

In an embodiment of the surface acoustic wave device according to the present invention, the sum of the width of the first and/or second comb-formed electrode fingers and the width of the spacing between the adjacent fingers in the first and/or second comb-formed electrode fingers is identical to a half of the wave length of the surface acoustic wave.

In an embodiment of the surface acoustic wave device according to the present invention, the sum of the width of the first and/or second comb-formed electrode fingers and the width of the spacing between the adjacent fingers in the first and/or second comb-formed electrode fingers is identical to a quarter of the wave length of the surface acoustic wave.

In an embodiment of the surface acoustic wave device according to the present invention, a plurality of the first and/or second inter-digital transducers are arranged alternatively to each other in the propagation direction of the surface acoustic wave.

In an embodiment of the surface acoustic wave device according to the present invention, a multi-strips coupler is disposed between the first inter-digital transducer and the second inter-digital transducer.

In an embodiment of the surface acoustic wave device according to the present invention, a pair of opposing grating reflectors are disposed behind the first and second inter-digital transducers so that the first and second inter-digital transducers are arranged between the reflectors along the propagation direction of the surface acoustic wave.

In an embodiment of the surface acoustic wave device according to the present invention, the first and/or second inter-digital transducers are apodizing type inter-digital transducers.

In an embodiment of the surface acoustic wave device according to the present invention, the first and/or second inter-digital transducers are withdrawal weighting type inter-digital transducers.

### 〈Brief Description of Drawings〉

Fig.1 is a plan view of a surface acoustic wave device according to the embodiment 1 of the present invention.
Fig.2 is a plan view of a surface acoustic wave device according to the embodiment 2 of the present invention.
Fig.3 is a plan view of a surface acoustic wave device according to the embodiment 3 of the present invention.
Fig.4 is a plan view of a surface acoustic wave device according to the embodiment 4 of the present invention.
Fig.5 is a plan view of a surface acoustic wave device according to the embodiment 5 of the present invention.
Fig.6 is a plan view of a surface acoustic wave device according to the embodiment 6 of the present invention.
Fig.7 is a plan view of a surface acoustic wave device according to the embodiment 7 of the present invention.
Fig.8 is a plan view of a surface acoustic wave device in the prior art.
Fig.9 is a plan view of another surface acoustic wave device in the prior art.

### 〈Best mode for Carrying out the Invention〉

Embodiments of the surface acoustic wave device according to the present invention are explained below.

### EMBODIMENT 1

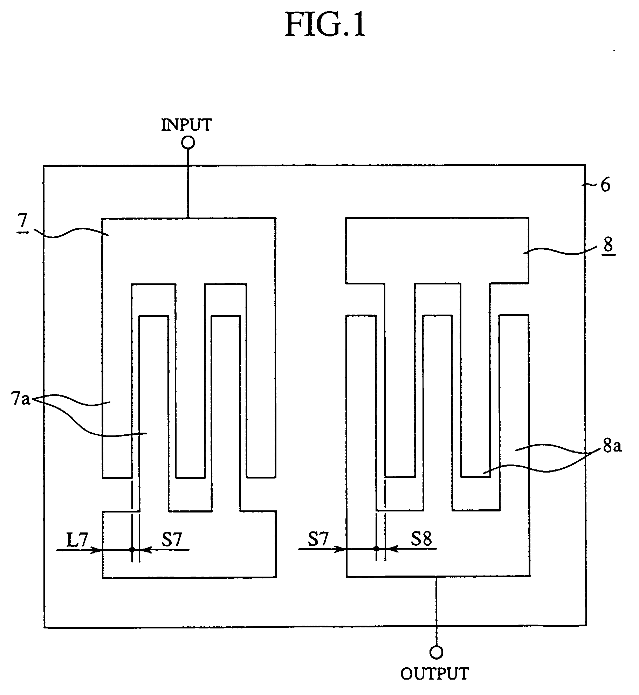

The surface acoustic wave device according to the embodiment 1 is explained below, referring to Fig.1.

Fig.1 is a plan view of the surface acoustic wave device according to the present invention, in which the capacitance component of the input impedance and output impedance can be adjusted, without using a capacitance element.

The input side IDT 7 has comb-formed electrode fingers 7a, and the output side IDT 8 has comb-formed electrode fingers 8a. Reference numerals L7 and L8 denote the width of the comb-formed electrode fingers 7a and 8a, respectively. And the reference numerals S7 and S8 denote the distance of the spacing between the adjacent comb-formed electrode fingers 7a and 8a, respectively.

Components in Fig.1 identical or equivalent to components in the surface acoustic wave device in the prior art shown in Fig.9 are referred by corresponding reference numerals, and their explanations are omitted, here. And only different points are explained.

The capacitance between the comb-formed electrodes fingers 7a can be adjusted, by varying the distances S7. The capacitance between the comb-formed electrodes fingers 8a can be adjusted, by varying the distances S8.

In this embodiment, each of the comb-formed electrode fingers 7a and 8a of the input side IDT 7 and output side IDT 8 elongates into the spacing between the opposing comb-formed electrode fingers 8a and 7a, mutually. The sum of the width L of the comb-formed electrode fingers and the distance S of the spacing of adjacent comb-formed electrode fingers corresponds to a half of the wave length of the propagating surface acoustic wave. A surface acoustic wave device such as shown in the embodiment 1 is called "a single electrode type surface acoustic wave device" in this specification.

The capacitance component of the input impedance and the output impedance at the input side IDT 7 and the output side IDT 8 can be adjusted to a desired value, by adjusting the distance of the spacings between the comb-formed electrode fingers 7a and 8a, respectively, so that the impedance matching to outer circuits to be connected with the input terminal 1 and the output terminal 2 can be attained.

Same effects can be attained, when the widths L7 and L8 of the comb-formed electrode fingers 7a and 8a in the input side IDT 7 and output side IDT 8 are adjusted so as to vary the proportion of the width of the comb-formed electrode fingers to the distance of the spacing between the comb-formed electrode fingers, instead of adjusting the distance between the comb-formed electrode fingers.

Even when an outer circuit connected to the input terminals 1 and another outer circuit connected to the output terminal 2 require different impedances to the surface acoustic wave device, the impedance matchings with the outer circuits at the input side and output side can be carried out exactly and independently, by adjusting the distance of the spacings between the comb-formed electrodes 7a and 8a in the input side IDT 7 and output side IDT 8, respectively.

The total volume of the surface acoustic wave device can be downsized, because the space for a capacitance element, which is used in the prior art, can be eliminated from the substrate 6.

When the widths of the comb-formed electrode fingers 7a and 8a of the input side IDT 7 and the output side IDT 8 are designed to be constant, the fabrication of the surface acoustic wave device can be facilitated.

Specifically, when the width of the comb-formed electrode fingers is larger than three times of the distance between the comb-formed electrode fingers in the input side IDT 7 and the output side IDT 8, respectively, the capacitance can be obtained more effectively.

### EMBODIMENT 2

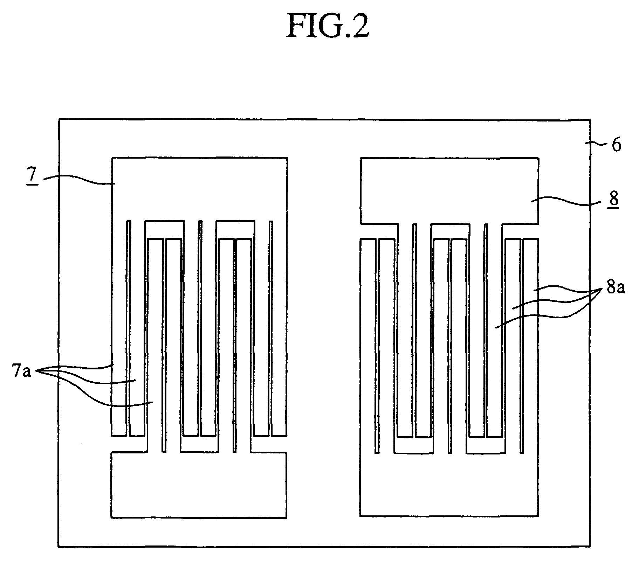

The surface acoustic wave device according to another embodiment is explained below, referring to Fig.2.

Fig.2 is a plan view of the surface acoustic wave device according to the embodiment 2 of the present invention, in which the capacitance component of the input impedance and output impedance can be adjusted, without using a capacitance element.

Components in Fig. 2 identical or equivalent to components in the surface acoustic wave device according to the embodiment 1 shown in Fig.1 are referred by corresponding reference numerals, and their explanations are omitted. And only different points are explained.

In this embodiment, each two adjacent comb-formed electrode fingers 7a and 8a of the input side IDT 7 and output side IDT 8 are paired, and the paired comb-formed electrode fingers 7a and 8a elongate between the spacing of the opposing pairs of the comb-formed electrode fingers 8a and 7a, mutually. The sum of the width L of the comb-formed electrode fingers and the distance S of the spacing of adjacent comb-formed electrode fingers corresponds to a quarter of the wave length of the propagating surface acoustic wave. A surface acoustic wave device such as shown in the embodiment 2 is called "a double electrodes type surface acoustic wave device" in this specification.

When the surface acoustic wave device has double electrodes type comb-formed electrodes in the input side and output side IDT 7 and IDT 8, the diffusion of the surface acoustic wave is small, therefore the surface acoustic wave can be effectively transmitted and received.

### EMBODIMENT 3

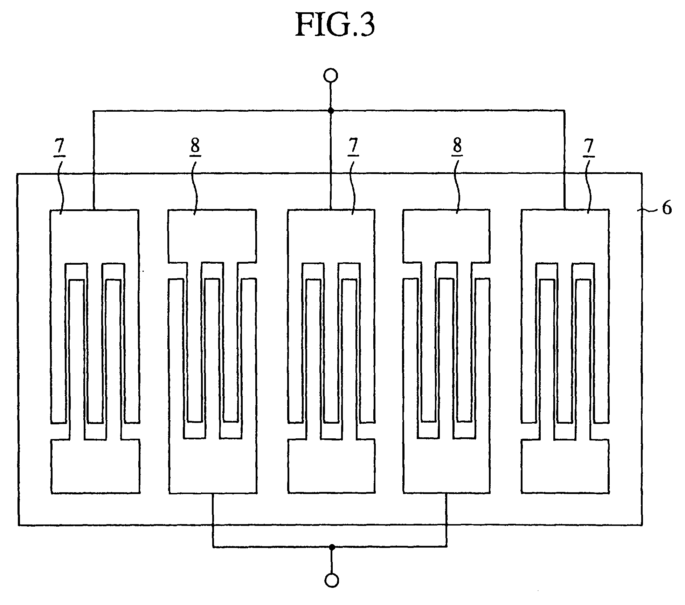

The surface acoustic wave device according to another embodiment is explained below, referring to Fig.3.

Fig.3 is a plan view of the surface acoustic wave device according to embodiment 3 of the present invention, in which the capacitance component of the input impedance and output impedance can be adjusted, without using a capacitance element.

The surface acoustic wave device of this embodiment comprises three input side IDTs 7 and two output side IDTs 8. Namely, as shown in the figure, the surface acoustic wave device according to this embodiment of the present invention can have a plurality of input side IDTs 7 and output side IDTs 8.

Components in Fig.3 identical or equivalent to components in the surface acoustic wave device according to the embodiment 1 shown in Fig.1 are referred by corresponding reference numerals, and their explanations are omitted.

When the surface acoustic wave device has a plurality of input side and/or output side IDTs 7 and IDTs 8, the surface acoustic wave can be effectively transmitted and received.

### EMBODIMENT 4

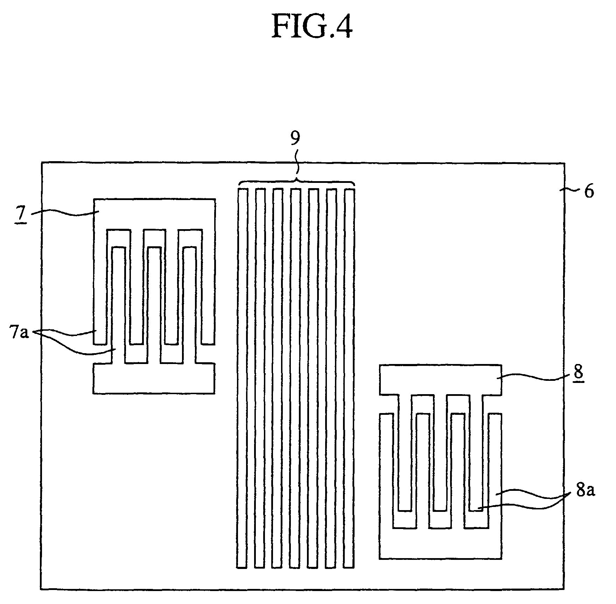

The surface acoustic wave device according to another embodiment is explained below, referring to Fig.4.

Fig.4 is a plan view of the surface acoustic wave device according to embodiment 4 of the present invention, in which the capacitance component of the input impedance and output impedance can be adjusted, without using a capacitance element.

Reference numeral 9 denotes a multi-strip coupler disposed between the input side IDT 7 and the output side IDT 8. The surface acoustic wave generated by the input side IDT 7 is purified by the multi-strip coupler 9 so that the surface acoustic wave can be transmitted to the output side IDT 8, without being disturbed by an external electromagnetic wave.

Components in Fig.4 identical or equivalent to components in the surface acoustic wave device according to the embodiment 1 shown in Fig.1 are referred by corresponding reference numerals, and their explanations are omitted. And only different points are explained.

When the surface acoustic wave device has a multi-strip coupler 9, the propagation of unnecessary surface acoustic wave can be decreased, so that necessary surface acoustic wave can be effectively received.

### EMBODIMENT 5

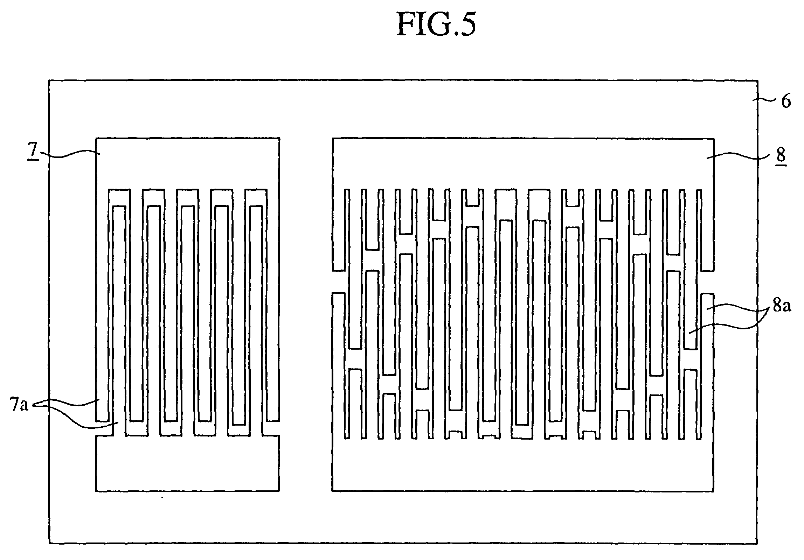

The surface acoustic wave device according to another embodiment is explained below, referring to Fig.5.

Fig.5 is a plan view of the surface acoustic wave device according to embodiment 5 of the present invention, in which the capacitance component of the input impedance and output impedance can be adjusted, without using a capacitance element.

In this embodiment, the IDTs are apodizing type IDTs. The length of the comb-formed electrode fingers of the output side IDT 8 of the surface acoustic wave device is weighted, namely the overlap between adjacent fingers of the IDT is varied, so as to modifying the response of a surface acoustic wave, namely to obtain a so-called apodization effect.

On the contrary, the input side IDT 7 can be an apodizing type IDT, to obtain an apodization effect.

Components in Fig.5 identical or equivalent to components in the surface acoustic wave device according to the embodiment 1 shown in Fig.1 are referred by corresponding reference numerals, and their explanations are omitted.

Using an apodizing type IDT, the freedom in designing the input side IDT7 and/or the output side IDT 8 can be augmented.

### EMBODIMENT 6

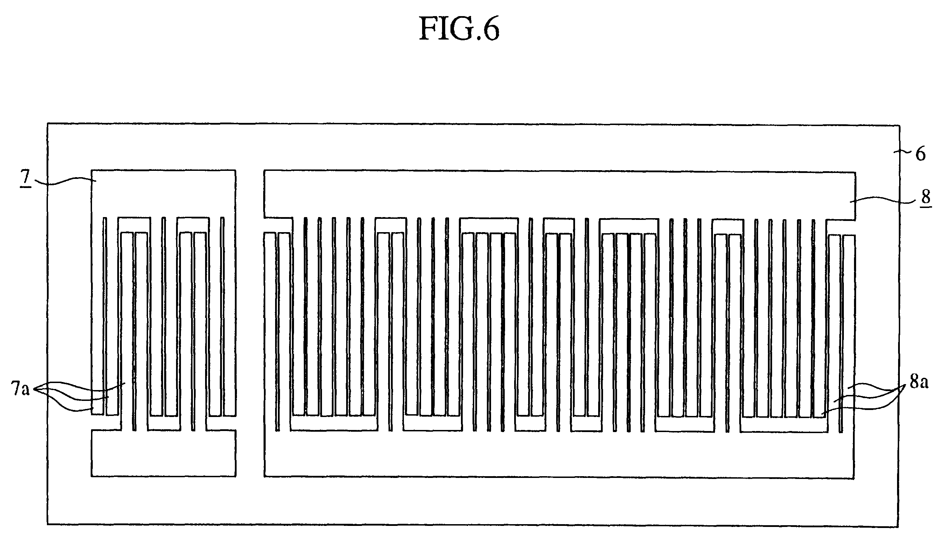

The surface acoustic wave device according to another embodiment is explained below, referring to Fig.6.

Fig.6 is a plan view of the surface acoustic wave device according to the embodiment 6 of the present invention, in which the capacitance component of the input impedance and output impedance can be adjusted, without using a capacitance element.

In this embodiment, the output side IDT 8 is a withdrawal type IDT, and both of the input side IDT 7 and the output side IDT 8 are double electrode type IDTs. The comb-formed electrode fingers of the output side IDT 8 of the surface acoustic wave device are grouped, and the grouping is weighted inhomogeneously. Namely, in this embodiment, a group of comb-formed electrode fingers 8a in the output side IDT 8 elongates into the spacing of opposing adjacent groups of the comb-formed electrode fingers 8a, mutually. The numbers of the comb-formed fingers in each of the groups are not constant, but are designed so as to reduce a diffraction effect.

When the comb-formed electrode fingers of the input side IDT 7, in stead of the output side IDT 8, of the surface acoustic wave device are withdrawal weighting type inter-digital transducers, same effects can be obtained.

Components in Fig.6 identical or equivalent to components in the surface acoustic wave device according to the embodiment 1 shown in Fig.1 are referred by corresponding reference numerals, and their explanations are omitted.

The diffraction of the surface acoustic wave can be reduced, by using a withdrawal weighting type inter-digital transducer, namely, by weighting the grouping of comb-formed electrode fingers of the input side IDT 7 and/or output side IDT 8 of the surface acoustic wave device, so that the receiving efficiency of the surface acoustic wave can be improved.

### EMBODIMENT 7

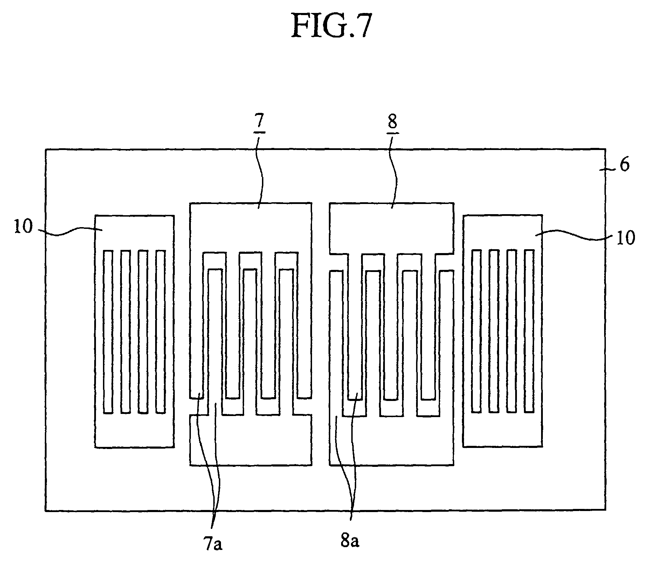

The surface acoustic wave device according to another embodiment is explained below, referring to Fig.7

Fig.7 is a plan view of the surface acoustic wave device according to the embodiment 7 of the present invention, in which the capacitance component of the input impedance and output impedance can be adjusted, without using a capacitance element.

In this embodiment, a pair of grating reflectors 10 are disposed behind the input side IDT 7 and the output side IDT 8. The input side IDT 7 and the output side IDT 8 are disposed between the pair of the grating reflectors 10. The surface acoustic wave outputted from the input side IDT 7 resonates in the pair of the grating reflectors 10 at a predetermined wave length, and the resonating wave is received by the output side IDT 8.

Components in Fig.7 identical or equivalent to components in the surface acoustic wave device according to the embodiment 1 shown in Fig.1 are referred by corresponding reference numerals, and their explanations are omitted. And only the different points are explained.

Using the grating reflectors 10, the efficiency of the sending and receiving of the surface acoustic wave can be improved, and the freedom in designing the surface acoustic wave device increases.

As explained, a surface acoustic wave device according to the present invention comprises: a substrate; a first inter-digital transducer for transducing an input electric signal to an output surface acoustic wave, which has a set of first comb-formed electrode fingers and is disposed on the substrate; a second inter-digital transducer for transducing the input surface acoustic wave signal to an output electric signal, which has a set of second comb-formed electrode fingers and is disposed on the substrate; wherein the proportion of the width of a finger in the first comb-formed electrode fingers to the width of the spacing between the adjacent fingers in the first comb-formed electrode fingers can be different from the proportion of the width of a finger in the second comb-formed electrode fingers to the width of the spacing between the adjacent fingers in the second comb-formed electrode fingers.

Therefore, it is possible to adjust the capacitance component of the input impedance and the output impedance, by adjusting the width of the comb-formed electrode fingers and/or the width of the spacing between adjacent comb-formed electrode fingers in the input side IDT and/or output side IDT. That is to say, the capacitance component of the input impedance and the output impedance can be adjusted by the structure itself of the input side IDT and/or output side IDT. As a result, it is possible to eliminate a space on the substrate for disposing a capacitance element for adjusting the input impedance and output impedance, as was required in the prior art. Consequently, the total size of the surface acoustic wave device can be downsized.

In an embodiment of the surface acoustic wave according to the present invention, the width of a finger in the first comb-formed electrode fingers is larger than three times of the width of spacing between the adjacent fingers in the first comb-formed electrode fingers and/or in the second comb-formed electrode fingers, so that the fabrication of the surface acoustic wave device can be simplified, as a whole.

In an embodiment of the surface acoustic wave device according to the present invention, the width of the first comb-formed electrode fingers and/or the second comb-formed electrode fingers is identical, so that the fabrication of the surface acoustic wave device can be simplified, as a whole.

In an embodiment of the surface acoustic wave device according to the present invention, the sum of the width of the first and/or second comb-formed electrode fingers and the width of the spacing between the adjacent fingers in the first and/or second comb-formed electrode fingers is identical to a half of the wave length of the surface acoustic wave, so that the fabrication of the surface acoustic wave device can be simplified.

In an embodiment of the surface acoustic wave according to the present invention, the sum of the width of the first and/or second comb-formed electrode fingers and the width of the spacing between the adjacent fingers in the first and/or second comb-formed electrode fingers is identical to a quarter of the wave length of the surface acoustic wave, so that the diffusion of the surface acoustic wave is small. Therefore, the surface acoustic wave can be effectively transmitted and received.

In an embodiment of the surface acoustic wave according to the present invention, a plurality of the first inter-digital transducers and/or a plurality of second inter-digital transducers are arranged alternatively to each other in the propagation direction of the surface acoustic wave, so that the surface acoustic wave can be effectively transmitted and received.

In an embodiment of the surface acoustic wave according to the present invention, a multi-strips coupler is disposed between the first inter-digital transducer and the second inter-digital transducer, so that the propagation of unnecessary surface acoustic wave can be decreased, therefore, necessary surface acoustic wave can be effectively received.

In an embodiment of the surface acoustic wave according to the present invention, a pair of opposing grating reflectors are disposed behind the first and second inter-digital transducers so that the first and second inter-digital transducers are arranged between the reflectors along the propagation direction of the surface acoustic wave. Therefore, the efficiency of the transmission and receiving of the surface acoustic wave can be improved.

In an embodiment of the surface acoustic wave according to the present invention, the first and/or second inter-digital transducers are apodizing type inter-digital transducers, so that the freedom in designing the input side IDT and the output side IDT can be augmented.

In an embodiment of the surface acoustic wave according to the present invention, the first and/or second inter-digital transducers are withdrawal weighting type inter-digital transducers, therefore the efficiency of the receiving of the necessary surface acoustic wave can be improved.

### 〈Industrial Applicability〉

The input impedance and output impedance of the surface acoustic wave device according to the present invention can be adjusted by the structure of inter-digital transducers, and can be used in products containing integrated circuits for micro waves.

## Claims

1. A surface acoustic wave device comprising:
a substrate;
a first inter-digital transducer for transdusing an input electric signal to an output surface acoustic wave, which is disposed on the substrate and has a set of first comb-formed electrode fingers ;
a second inter-digital transducer for transducing the input surface acoustic wave signal to an output electric signal, which is disposed on the substrate and has a set of second comb-formed electrode fingers; wherein
the proportion of the width of a finger in the first comb-formed electrode fingers to the width of the spacing between the adjacent fingers in the first comb-formed electrode fingers can be different from the proportion of the width of a finger in the second comb-formed electrode fingers to the width of the spacing between the adjacent fingers in the second comb-formed electrode fingers.

2. A surface acoustic wave device according to Claim 1, wherein the width of a finger in the first and/or second comb-formed electrode fingers is larger than three times of the width of spacing between the adjacent fingers in the first and/or second comb-formed electrode fingers.

3. A surface acoustic wave device according to one of Claims 1 and 2, wherein the widths of the first and/or second comb-formed electrode fingers are constant.

4. A surface acoustic wave device according to one of Claims 1 to 3, wherein the sum of the width of the first and/or second comb-formed electrode fingers and the width of the spacing between the adjacent fingers in the first and/or second comb-formed electrode fingers is identical to a half of the wave length of the surface acoustic wave.

5. A surface acoustic wave device according to one of Claims 1 to 3, wherein the sum of the width of the first and/or second comb-formed electrode fingers and the width of the spacing between the adjacent fingers in the first and/or second comb-formed electrode fingers is identical to a quarter of the wave length of the surface acoustic wave.

6. A surface acoustic wave device according to one of Claims 1 to 5, wherein a plurality of the first and/or second inter-digital transducers are arranged alternatively in the propagation direction of the surface acoustic wave.

7. A surface acoustic wave device according to one of Claims 1 to 6, wherein a multi-strips coupler is disposed between the first inter-digital transducer and the second inter-digital transducer.

8. A surface acoustic wave device according to one of Claims 1 to 7, wherein a pair of opposing grating reflectors are disposed behind the first and second inter-digital transducers so that the first and second inter-digital transducers are arranged between the reflectors along the propagation direction of the surface acoustic wave.

9. A surface acoustic wave device according to one of Claims 1 to 8, wherein the first and/or second inter-digital transducers are apodizing type inter-digital transducers.

10. A surface acoustic wave device according to one of Claims 1 to 9, wherein the first and/or second inter-digital transducers are withdrawal weighting type inter-digital transducers.
